(19) Europäisches Patentamt
European Patent Office
Office européen des brevets

(11) **EP 3 588 775 A1**

(12) **EUROPEAN PATENT APPLICATION**

(43) Date of publication:
**01.01.2020 Bulletin 2020/01**

(51) Int Cl.:
**H03F 3/45** (2006.01)   **H03F 3/72** (2006.01)
**H03F 3/187** (2006.01)

(21) Application number: **18180728.0**

(22) Date of filing: **29.06.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **IMEC vzw
3001 Leuven (BE)**

(72) Inventors:
• GUERMANDI, Davide
  3001 Leuven (BE)
• MATTIA, Oscar Elisio
  3001 Leuven (BE)
• CRANINCKX, Jan
  3001 Leuven (BE)

(74) Representative: **AWA Sweden AB
P.O. Box 5117
200 71 Malmö (SE)**

(54) **DYNAMIC AMPLIFIER WITH COMMON MODE VOLTAGE CONTROL**

(57)    This invention relates to a dynamic amplifier comprising a first and a second input. The dynamic amplifier includes first and second capacitor means each comprising first and second terminal means. The first capacitor means is connected to a first output of the dynamic amplifier for receiving a first current at its first terminal means in response to receiving a signal at the first input of the dynamic amplifier. The second capacitor means is connected to a second output of said dynamic amplifier for receiving a second current at its first terminal means in response to receiving a signal at the second input of the dynamic amplifier. The dynamic amplifier includes discharging circuitry connected to the second terminal means of the first and second capacitor means and is adapted to continuously lower a voltage potential at the second terminal means of the first and second capacitor means.

Fig. 2a

**Description**

**Technical field**

The present invention generally relates to dynamic amplifiers, and more particular to a dynamic amplifier and method for controlling common mode voltage present at the output of the dynamic amplifier.

**Background of the invention**

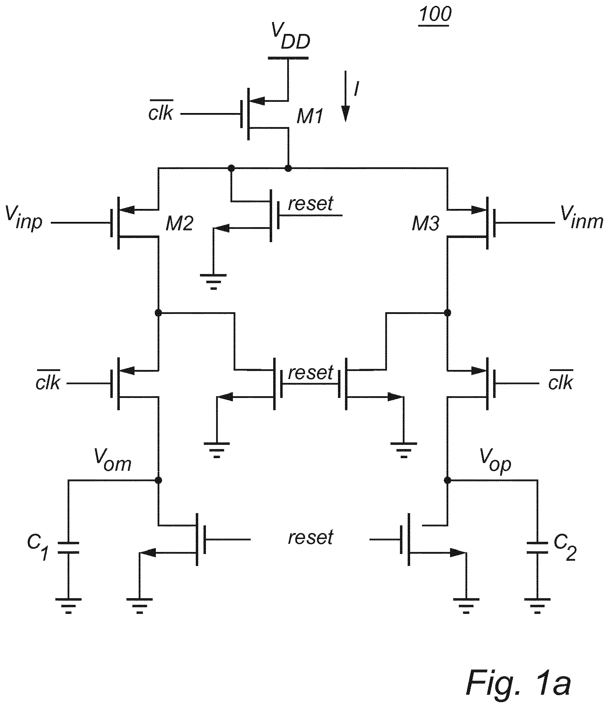

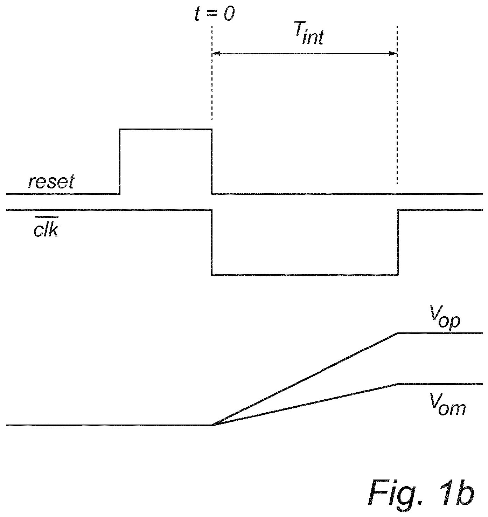

Dynamic amplifiers are widely used in pipelined successive approximation register analog-to-digital converters, SAR ADCs, due to their high current efficiency and simplicity. Figures 1a and 1b illustrate by way of example a prior art PMOS dynamic amplifier 100. A current drained from the positive rail is steered and integrated over 2 capacitors proportionally to the input voltage for a given time to produce the desired output differential voltage. The capacitances at the output of the amplifier can be the input or sampling capacitances of the next stage connected to the output of the amplifier, or dedicated capacitances explicitly placed for integration.

When the signal "reset" is high the capacitors C1 and C2 in figure 1a and the internal nodes of the amplifier are discharged while transistor M1 is turned off. After the reset phase, when the signal "not clk" goes low, M1 turns on and the current I flows through the differential pair M2 and M3. Depending on the input voltage Vinp-Vinm (> 0 in the case shown in Figure 1b) the current I is split through the differential pair M2 and M3 and linearly charge the capacitances C1 and C2 with different rates. The differential output voltage, Vop-Vom, rises over time proportionally to the differential input voltage, Vinp-Vinm, as long as the transistors M2 and M3 operates as a differential transconductor gm, while the common mode voltage, (Vop+Vom) / 2, rises proportionally to the input common mode voltage. Both voltages rise proportionally to the integration time, Tint. The behavior of the output voltage can be described by equations (1) and (2):

$$Vodiff(t) = Vop(t) - Vom(t) = (Vip - Vim) * gm * Tint / C \qquad (1)$$

$$Vocm(t) = (Vop(t)+Vom(t)) / 2 = I * Tint / (2 * C) \qquad (2)$$

where gm is the transconductance of M2 and M3. The ratio of the differential output voltage over the common mode voltage is time independent and given by:

$$Vocm / Vodiff = 2 * gm / I \qquad (3)$$

For a MOS transistor the ratio of its transconductance gm and current I is fixed by semiconductor properties in the range 10 to 16 for reasonable transistor sizes. For the differential pair of figure 1a, the above ratio is therefore in the range 5 to 8, i.e.:

$$gm / I = 5 \text{ to } 8 \qquad (4)$$

A common gain value for a pipeline-SAR architecture is normally 4. To achieve this gain, the integration time and the capacitance are chosen such that:

$$gm * Tint / C = 4 \qquad (5)$$

Solving this equation for Tint gives:

$$Tint = 4 * C / gm \qquad (6)$$

Inserting equation (6) into equation (2) gives:

$$Vocm(Tint) = 2 I / gm \qquad (7)$$

And inserting equation (4) into equation (7) gives:

$$Vocm(Tint) = 250mV\text{-}400mV \qquad (8)$$

Double values are expected for a gain of 8 that requires a double integration time or a double current. The voltage shown in equation (8) is considerably high under a sub-1V supply typical of advanced CMOS technology and may push the differential pair M2 and M3 close to triode region (especially if the input common mode voltage is low) making the differential output voltage not linear with time and affecting amplifier linearity.

Also, an output common mode at the end of the integration around half the value of positive rail may be not optimal to drive the following stage because it results in low overdrive for both NMOS and PMOS inputs.

The document "A complementary dynamic residue amplifier for a 67 dB SNDR 1.36 mW 170 MS/s pipelined SAR ADC" by B. Malki, B. Verbruggen, P. Wambacq, K. Deguchi, M. Iriguchi and J. Craninckx, ESSCIRC 2014 - 40th European Solid State Circuits Conference (ESSCIRC), Venice Lido, 2014, pp. 215-218 discloses the use of complementary amplifiers which allows control of the common mode voltage. However, when using a complementary amplifier, the VGS of the transistors (NMOS and PMOS) is limited to VDD/2, resulting in low current and longer integration time. Moreover, the output common mode still can go very high in the first part of the integration, resulting in a less linear behavior for the amplifier.

The documents "A 1.5 mW 68 dB SNDR 80 Ms/s 2 x Interleaved Pipelined SAR ADC in 28 nm CMOS", by F. van der Goes et al., IEEE Journal of Solid-State Circuits, vol. 49, no. 12, pp. 2835-2845, Dec. 2014, and "A 1.7 mW 11b 250 MS/s 2-Times Interleaved Fully Dynamic Pipelined SAR ADC in 40 nm Digital CMOS" by B. Verbruggen, M. Iriguchi and J. Craninckx, IEEE Journal of Solid-State Circuits, vol. 47, no. 12, pp. 2880-2887, Dec. 2012 discloses amplifiers where the output common mode is detected and above a defined threshold the integration is interrupted. Apart from suffering from the previously mentioned linearity limitation, this approach does not decouple common mode and differential mode output voltage unless two stages are used, with an obvious power and area penalty.

The document "High-gain and power-efficient dynamic amplifier for pipelined SAR ADCs" by Y. Lyu, A. Ramkaj and F. Tavernier, ELECTRONICS LETTERS 9th November 2017 Vol. 53 No. 23 pp. 1510-1512 discloses a dynamic amplifier which uses a clocking scheme to charge and discharge the output nodes in order to mitigate the effects of a large common mode voltage. After individually charging the output nodes to a predefined level, Vref, the output nodes are discharged in response to signals at the input of the amplifier. A common-mode detector is used to stop the discharging phase and freeze the output voltages once the output common mode voltage reaches a certain threshold. Also this approach suffers from the previously mentioned linearity limitation and an increased complexity.

The document "A 150 kHz-80 MHz BW Discrete-Time Analog Baseband for Software-Defined-Radio Receivers using a 5th-Order IIR LPF, Active FIR and a 10 bit 300 MS/s ADC in 28 nm CMOS" Badr Malki; Bob Verbruggen; Ewout Martens; Piet Wambacq; Jan Craninckx, IEEE Journal of Solid-State Circuits discloses a residue amplifier which uses a charging current on the "top plate" of a capacitance and a discharging current on the "top plate" of the other to limit the common mode excursion. It however needs a complicate feedback to make sure the charging and discharging currents are not (too) different to keep the common mode voltage in control. Because of this common mode feedback current is not constant over the integration phase and there is not a direct control of the common mode voltage. Moreover 8 transistors are found between the supply rail and ground reducing the available overdrive of amplifying transistors.

Thus, there is a need in the art for a dynamic amplifier which provides an improved control and limitation of the common mode voltage.

## Summary of the invention

In view of the above, an objective of the present invention is to provide a dynamic amplifier with an improved control of the common mode voltage of the dynamic amplifier during the integration time, making it lower than the differential voltage (ideally zero). This prevents the amplifier from going into nonlinear region. Additionally, a dynamic amplifier according to the present invention can provide an output common mode voltage that is close to one of the power rails (VSS, ground or VDD) or to any other desired value between ground and VDD, beneficial to maximize the overdrive of the following stage.

These and other objects are achieved by providing a logic circuit having the features defined in the independent claims. Preferred embodiments are defined in the dependent claims.

According to a first aspect of the present invention there is provided a dynamic amplifier for amplifying a signal in a first time interval under control of a clock signal. The dynamic amplifier comprises a first input and a second input. The dynamic amplifier includes first capacitor means comprising first and second terminal means. The first capacitor means is connected to a first output of the dynamic amplifier for receiving a first current at its first terminal means in the first time interval in response to receiving a signal at the first input of the dynamic amplifier.

The dynamic amplifier includes second capacitor means comprising first and second terminal means. The second capacitor means is connected to a second output of said dynamic amplifier for receiving a second current at its first terminal means in the first time interval in response to receiving a signal at the second input of the dynamic amplifier.

The dynamic amplifier includes discharging circuitry connected to the second terminal means of the first and second capacitor means and is adapted to continuously lower a voltage potential at the second terminal means of the first and second capacitor means in the first time interval.

The first current and the second current depend on the signals at the first input and at the second input. The difference of the first current and the second current is directly related to the difference of the first input signal and the second input signal. The average of the first current and the second current may be independent or depend on the first input signal and second input signal.

In the following text the terms "top plate" and "bottom plate" will be used interchangeably with the terms "first terminal" and "second terminal" for reference to the two connections available on a capacitor.

The present invention is based on the idea of mitigating the effects of common mode voltage building up over the output capacitors during the integration interval due to common mode current flowing into the first terminals, by continuously lowering the voltage potential at the second terminals of the output capacitors. Thus an advantage with the present invention is that by providing discharging circuitry which continuously lowers the voltage potential at the bottom plates of the capacitors during integration, the effects of a common mode voltage building up at the top plates during integration will be mitigated due to the fact that the output common mode voltage of the dynamic amplifier will effectively be the sum of the voltage resulting from integration of currents received at the top plates and the voltage controlled at the bottom plates.

The dynamic amplifier comprises a first and second input. By the term first and second input is here meant any conductors or terminals that are adapted to receive signals that will be amplified by the dynamic amplifier. The first and second inputs may be directly connected to the gates of two MOS-type transistors. The first and second input may be connected to circuitry for protection against electrostatic discharge at the inputs.

The dynamic amplifier comprises a first and second output. By the term first and second output is here meant any conductors or terminals that are adapted to provide an amplified version of the input signal to a following stage or other circuitry connected to the outputs.

The present invention comprises first and second capacitance means. By the term capacitance means is here meant one or more capacitors connected in parallel and/or series in order to create a charge storage of a suitable size for receiving a current flowing into the capacitor means during the first time interval. It is appreciated that the physical form and construction of practical capacitors vary widely. Capacitors are available both as discrete components and as integrated parts in integrated circuits. Most capacitors contain at least two electrical conductors often in the form of metallic plates or surfaces separated by a dielectric medium. A conductor may by way of example be a foil, thin film, sintered bead of metal, an electrolyte, or a metal deposition used in IC technology. The nonconducting dielectric acts to increase the capacitor's charge capacity. Materials commonly used as dielectrics include glass, ceramic, plastic film, paper, mica, and oxide layers. The capacitance means may comprise a sampling capacitance of a following stage in a pipelined SAR ADC.

According to an embodiment of the present invention, the dynamic amplifier comprises charging circuitry that is connected to the second terminals of the first and second capacitor means and adapted to raise the voltage potential at the second terminals of the first and second capacitor means in a second time interval preceding the first time interval.

An advantage of this embodiment is that the second terminals (bottom plates) of the capacitor means may be pre-charged to a predetermined suitable voltage potential prior to being discharged in the first time interval. Thus, an exact control of the discharge with respect to rate and value may be achieved.

According to an embodiment of the present invention, the charging circuitry comprises at least one switch connected between positive rail and the second terminals of the first and second capacitor means and adapted to connect the second terminals of the first and second capacitor means to positive rail in the second time interval.

An advantage of this embodiment is that the second terminals (bottom plates) may be rapidly pre-charged to the voltage potential of the positive rail (VDD) enabling a compensation of common mode voltage over a large voltage span stretching from positive rail to negative rail (ground or VSS).

According to an embodiment of the present invention, the discharging circuitry comprises at least one current or voltage regulator connected to the second terminals of the first and second capacitor means, said current or voltage regulator adapted to pull a third current from the second terminals of the first and second capacitor means in the first time interval.

An advantage of this embodiment is that an effective way of compensating for the common mode voltage is achieved since the third current may be regulated such that it substantially corresponds to the common mode current flowing into the capacitors at the outputs of the dynamic amplifier (current I in equation (2)). Thus, the third current may be controlled directly by the current regulator or by the difference in potential between the bottom plates and the output of the voltage generator (via an internal or external resistance of the voltage regulator)

According to an embodiment of the present invention, the dynamic amplifier comprises a differential pair of MOS-type transistors connected to the first and second inputs, respectively, each MOS-type transistor in series connection with a respective switch for allowing the first and second currents to be received at the first terminals of the first and second capacitors in the first time interval under control of the clock signal, wherein the current regulator comprises a corresponding pair of MOS-type transistors and switches for generating a current that is mirrored to the second terminals of the first and second capacitor via a current mirror to generate the third current.

An advantage of this embodiment is that a replica of the current flowing into the capacitors at the output of the dynamic amplifier may be easily generated. The corresponding pair of MOS-type transistors and switches may be designed such that the current flowing through them is scaled in relation to the current flowing into the capacitors. A current mirror providing an inverse scaling of the current may then be used for generating the third current.

According to an embodiment of the present invention, the dynamic amplifier includes third capacitor means comprising a first and a second terminal, said third capacitor means connected to the first output of said dynamic amplifier for receiving a fourth current at its first terminal in the first time interval in response to receiving the signal at the first input of the dynamic amplifier, and fourth capacitor means comprising a first and a second terminal, said fourth capacitor means connected to the second output of said dynamic amplifier for receiving a fifth current at its first terminal in said first time interval in response to receiving the signal at the second input of the dynamic amplifier, wherein the second terminals of the third and fourth capacitor means are connected to signal ground.

An advantage of this embodiment is that a fraction of the integration capacitance is discharged from positive rail (VDD) to negative rail (ground or VSS). By adjusting the fraction in this embodiment, the final common mode voltage may be controlled with high precision.

According to an embodiment of the present invention, the third current has a magnitude that is substantially the same as the sum of the first and second currents.

An advantage of this embodiment is that the common mode voltage at the output of the dynamic amplifier may be kept at a very low value (ideally zero volts) during the first time interval (while the capacitors integrate the first and second currents to obtain the output signals).

According to an embodiment of the present invention, the third current has a magnitude that is smaller than the sum of the first and second currents.

An advantage of this embodiment is that the common mode voltage at the output of the dynamic amplifier may be allowed to rise during the first time interval (while the capacitors integrate the first and second currents to obtain the output signals) in order to safeguard that the signals at the outputs do not reach negative voltage that may exceed the safe operation range of a following stage.

According to an embodiment of the present invention, the discharge circuitry comprises switching means adapted to connect the second terminals of the first and second capacitor means to signal ground in a third time interval subsequent to the first time interval.

An advantage of this embodiment is that it is ensured that the bottom plates of the capacitors are fully discharged before starting a new amplification period including the pre-charging of the bottom plates in the second time period. It also ensured that during the third time interval the first output and second output are constants both in common and differential mode, and can be processed by the following stage.

According to an embodiment of the present invention, the first and second capacitor means each comprises a plurality of capacitors, $C_{1,n}$, $C_{2,n}$, $n \in [1: N]$, N being an integer larger than one, each of said plurality of capacitors comprising a first and a second terminal.

In other words, the first capacitance means comprises n capacitors indexed $C_{1,n}$ and the second capacitance means comprises n capacitors indexed $C_{2,n}$. The index n is in the range between 1 and N, where N is an integer. Hence the first and second capacitance means may each comprise 1, 2, 3, 4, etc. capacitors.

An advantage of this embodiment is that it enables effective control of the capacitors whose second terminal is discharged during the first time interval.

According to an embodiment of the present invention, the dynamic amplifier comprises a plurality of discharging circuits, wherein the first terminal of each capacitor $C_{1,n}$ is connected to the first output of the dynamic amplifier, and the first terminal of each capacitor $C_{2,n}$ is connected to the second output of the dynamic amplifier, and the capacitors of said first and second capacitor means form pairs for each value of n and wherein the second terminals of at least a portion of said capacitor pairs are each connected to one of the plurality of the discharging circuits.

An advantage of this embodiment is that the final common mode voltage may be effectively controlled.

In other words, the first capacitance means comprises n capacitors indexed $C_{1,n}$. For each of the n capacitors in the first capacitance means there is a corresponding capacitor $C_{2,n}$ in the second capacitance means, the two of which form a pair and have their bottom plates connected together. One or more of the capacitor pairs have their bottom plates connected to a discharging means.

According to a second aspect of the present invention there is provided a method for reducing output common mode voltage of a dynamic amplifier adapted to amplify a signal in a first time interval under control of a clock signal. The method comprises: charging first capacitor means connected to a first output of the amplifier by providing a first current to first terminal means of the first capacitor means in a first time interval in response to receiving a signal at a first input of the dynamic amplifier; charging a second capacitor means connected to a second output of the amplifier by providing a second current to first terminal means of the second capacitor means in a first time interval in response to receiving a signal at a second input of the dynamic amplifier, and ; continuously lowering a voltage potential at second terminal means of the first and second capacitor means, respectively, in said first time interval.

An advantage with the invention according to this aspect is that by continuously lowering the voltage potential at the second terminal means (bottom plates) of the capacitors during the first time interval (integration), the effects of a common mode voltage building up at the top plates during the first time interval will be mitigated

According to an embodiment of the present invention, the method comprises raising the voltage potential at the second terminal means of the first and second capacitor means, respectively, in a second time interval preceding the first time interval.

An advantage of this embodiment is that the second terminals (bottom plates) of the capacitor means may be pre-charged to a predetermined suitable voltage potential prior to being discharged in the first time interval. Thus, an exact control of the discharge with respect to rate and value may be achieved.

According to an embodiment of the present invention, the method comprises pulling a third current from the second terminal means of the first and second capacitor means in the first time interval.

An advantage of this embodiment is that an effective way of compensating for the common mode voltage is achieved since the third current may be regulated such that it substantially corresponds to the common mode current flowing into the capacitors at the outputs of the dynamic amplifier (current I in equation (2)).

According to an embodiment of the present invention, the method comprises connecting the second terminal means of the first and second capacitor means to signal ground in in a third time interval subsequent to the first time interval.

An advantage of this embodiment is that it is ensured that the bottom plates of the capacitors are fully discharged before starting a new amplification period including the pre-charging of the bottom plates in the second time period. A further advantage is also that it guarantees that the output common mode is fixed after the first time interval, when that voltage is processed by the following stage.

Other objectives, features and advantages of the present invention will appear from the following detailed disclosure, from the attached claims as well as from the drawings.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise. The steps of any method disclosed herein do not have to be performed in the exact order disclosed, unless explicitly stated.

**Brief description of the drawings**

The above, as well as additional objects, features and advantages of the present invention, will be better understood through the following illustrative and non-limiting detailed description of preferred embodiments of the present invention, with reference to the appended drawings, where the same reference numerals will be used for similar elements, wherein:

Fig 1a schematically illustrates a dynamic amplifier according to the prior art;
Fig. 1b diagrammatically illustrates the timing and output signals of the amplifier shown in Fig. 1a;
Figure 2a schematically illustrates a dynamic amplifier according to an embodiment of the present invention;
Fig. 2b diagrammatically illustrates the timing and output signals of the amplifier shown in Fig. 2a.
Fig. 3a schematically illustrates an embodiment of the present invention;
Fig. 3b diagrammatically illustrates the timing signals of the amplifier shown in Fig. 3a.

**Detailed description of preferred embodiments**

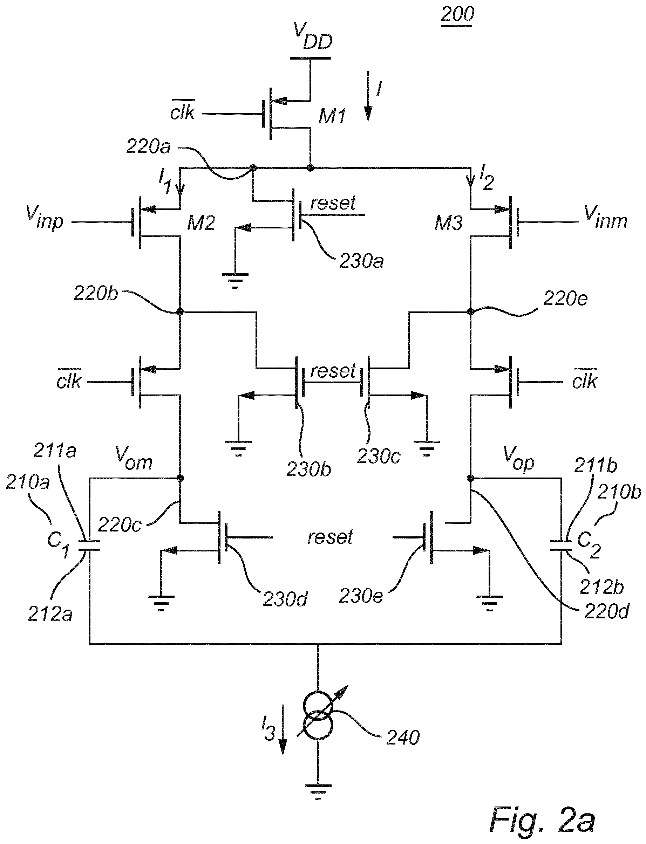

Figure 2a schematically illustrates the working principle of a differential dynamic amplifier 200 according to an embodiment of the present invention. When the signal "reset" is high the capacitors 210a-b and the nodes 220a-e of the amplifier are discharged via switches 230a-e while transistor M1 is turned off. At the same time the bottom plates of the capacitors 210a-b are pre-charged to positive rail (VDD). After the reset phase, when the signal "not clk" goes low, M1 turns on and a current I flows through the differential pair M2 and M3. Depending on the input voltage Vinp-Vinm the current I is split to a first current $I_1$ and second current $I_2$ through the differential pair M2 and M3 and is received at first terminals (top plates) 211a-b of the capacitors 210a-b in order to linearly charge the capacitors 210a-b with different rates. The differential output voltage, Vop-Vom, rises over time proportionally to the differential input voltage, Vinp-Vinm, as long as the transistors M2 and M3 operates as a differential transconductor gm. The currents $I_1$ and $I_2$ also give rise to a potential common mode voltage at the output of the dynamic amplifier. However, when the signal "not clk" goes low, a current regulator 240 becomes active and starts pulling a third current $I_3$ from the bottom plates 212a-b of the capacitors 210a-b. The third current $I_3$ may be adjusted such that it corresponds to the sum of the first and second currents, $I_1$, $I_2$. Alternatively, the current $I_3$ may be adjusted such that it is lower than the sum of the first and second currents, $I_1$, $I_2$, resulting in a slower discharging of the bottom plates. The sum of the first and second currents, $I_1$, $I_2$ can be substantially constant during the first time interval or depend on the first input and second input, i.e. in a more general sense, if M1 operates as an ideal switch it depends directly, if M1 operates as a current source it does not depend (it is fixed), and if M1 is in triode mode it somewhat depends.

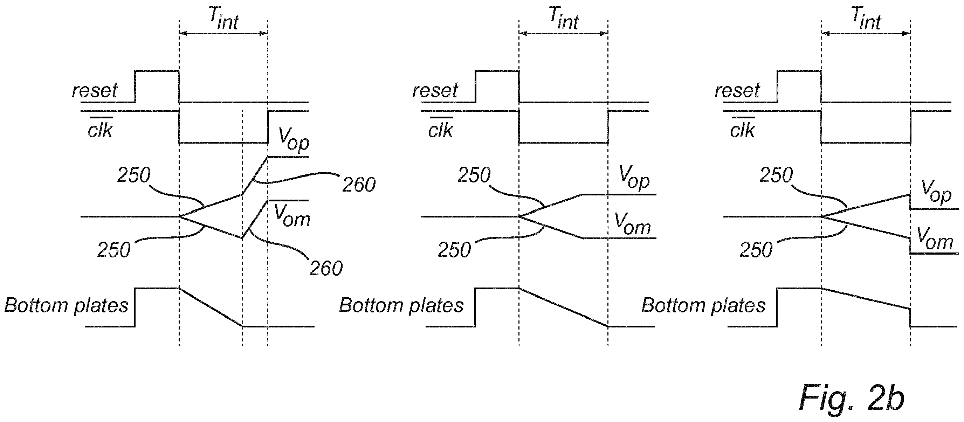

As can be seen from the diagrams in figure 2b, the discharging current $I_3$ may be such that the bottom plates are (left side) fully discharged before the end of the first time interval, indicated as Tint in the figures, (middle) discharged at the end of the first time interval, or (right side) not fully discharged at the end of the first time interval.

In the first case it can be seen from the left part of figure 2b that the differential signals Vop and Vom have a smaller slope 250 (Vop slightly positive and Vom slightly negative) while the bottom plates are discharging compared to the rising slopes 260 when the bottom plates are fully discharged. In the two other cases it can be seen from the right part of figure 2 that the differential signals Vop and Vom have a small slope 250 (Vop slightly positive and Vom slightly negative) during the entire first time interval.

It is hence possible to control the output common mode voltage (Vop+Vom)/2 at the end of the first time interval (Tint). Particularly it is possible to keep voltages Vop and Vom reasonably low during the integration time, keeping M2 and M3 well in saturation significantly improving the linearity of the amplifier. Moreover, the present invention provides a low output common mode voltage, beneficial if the next stage uses for example PMOS comparators.

When the signal "not clk" goes high, the bottom plates 212a-b of the capacitors 210a-b are connected to signal ground, resulting in a complete discharge of the bottom plates 212a-b (resulting in common mode step-down on the outputs as seen in the right part of figure 2b).

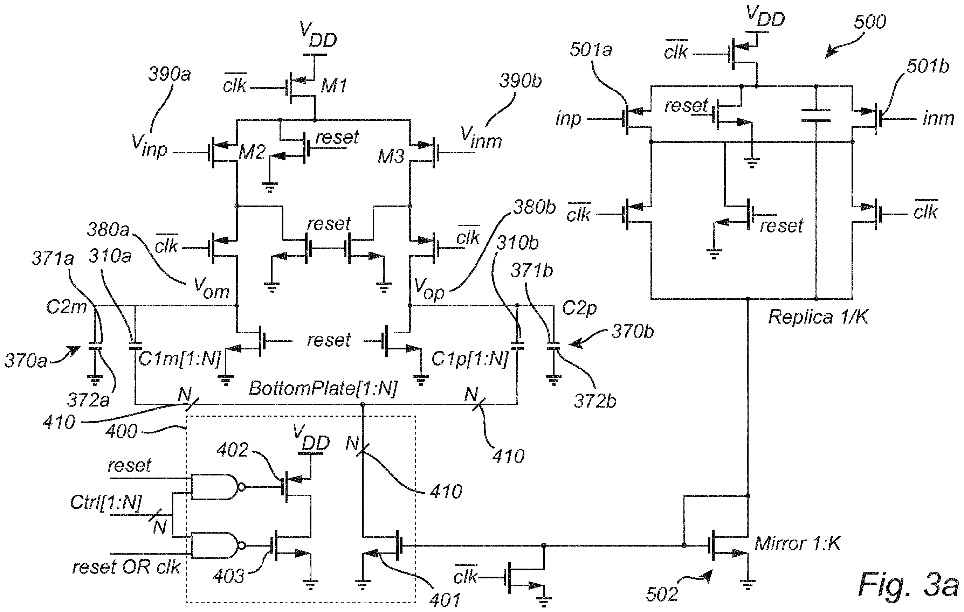

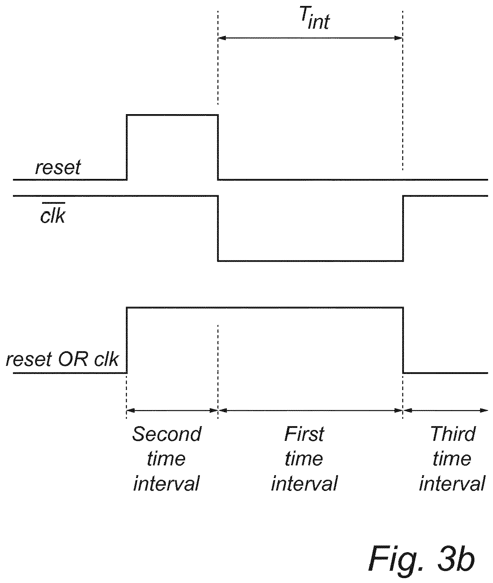

Figure 3a schematically illustrates an embodiment of the present invention. Figure 3b diagrammatically illustrates the timing signals of the amplifier shown in Fig. 3a.

In addition to the dynamic amplifier illustrated in figure 2a, the dynamic amplifier illustrated in figure 3a comprises third and fourth capacitor means C2m and C2p 370a-b, each of which comprises a first 371a-b and a second terminal 372a-b. The third and fourth capacitor means 370a-b are connected to the first and second outputs 380a-b of the dynamic amplifier, respectively, for receiving a fourth and a fifth current at their first terminals 371a-b in the first time interval in response to receiving the signal at the first and second inputs 390a-b of the dynamic amplifier. The second terminals 372a-b of the third and fourth capacitor means 370a-b are connected to signal ground.

The first and second capacitor means 310a-b may each comprise one capacitor each as disclosed above, but may also comprise a plurality of capacitors, $C_{1,n}$, $C_{2,n}$, $n \in [1:N]$, N being an integer larger than one as illustrated by the arrays C1m[1:N] and C1p[1:N] in figure 3a. The total capacitance seen at the first output of the dynamic amplifier will hence be the sum of the capacitances C1m[1:N] and the third capacitance means C2m 370a, and the total capacitance seen at the second output of the dynamic amplifier will be the sum of the capacitances C1p[1:N] and the fourth capacitance means C2p 370b. Each of the plurality of capacitors C1m[1:N] and C1p[1:N] comprises a first and a second terminal (top and bottom plate) in similarity with the disclosure above in relation to figure 2a. The first terminal of each capacitor $C_{1,n}$ is connected to the first output of the dynamic amplifier, and the first terminal of each capacitor $C_{2,n}$ is connected to the second output of the dynamic amplifier for receiving the integrating currents flowing through M2 and M3 in the first time interval. The capacitors $C_{1,n}$ and $C_{2,n}$ of the first and second capacitor means 310a-b form pairs for each value of n in that their respective bottom plates are connected to each other, i.e. the bottom plates of capacitors $C_{1,1}$ and $C_{2,1}$ are connected to each other, the bottom plates of capacitors $C_{2,1}$ and $C_{2,2}$ are connected to each other, etc.

According to this embodiment, the dynamic amplifier comprises a plurality of discharging circuits 400 indicated by the dashed line in figure 3a. Connections 410 are provided such that the bottom plates of one or more of the capacitor pairs are coupled to one of the plurality of discharging circuits as indicated by the letter N in figure 3a.

Each one of the discharging circuits comprises a discharge transistor 401 which controls the current drawn from the bottom plates of the first and second capacitor means 310a-b as will be disclosed in more detail below. A charge transistor 402 acting as a switch is connected between positive rail (VDD) and the second terminals (bottom plates) of the first and second capacitor means 310a-b and is adapted to connect the second terminals of the first and second capacitor means to positive rail in a second time interval preceding the first time interval (Tint). The charging transistor 402 precharges the bottom plates of the capacitors to VDD prior to the discharging in the first time interval. The precharging may be done such that the voltage level at the bottom plates is lower than VDD at the start of the first time interval, e.g. by connecting the charging transistor to a voltage level that is lower than VDD, or controlling the current flowing through the charging transistor (either by means of a series resistor, not shown, and/or by controlling the on-time of the charging transistor 402).

The discharge circuitry comprises a grounding transistor 403 which acts as a switch for connecting the second terminals of the first and second capacitor means 310a-b to signal ground in a third time interval subsequent to the first time interval (Tint). Both the charging transistor 402 and the grounding transistor 403 are controlled via the signals "reset", "reset OR clk" and select signal(s) "Ctrl[1:N]". The timing of the signals "not clk", "reset" and "reset OR clk" is shown in figure 3b. The select signal "Ctrl[1:N] is used for enabling the respective discharge circuitry in case of using multiple capacitors in the first and second capacitor means 310a-b. In case the dynamic amplifier only comprises one capacitor each in first and second capacitor means 310a-b, the signal "Ctrl[1:N]" is a single signal and may be omitted.

By controlling the number of capacitors that are discharged during the first time interval, it is possible to control the final common mode voltage that is present at the outputs at the end of the first time interval. The more capacitors of the first and second capacitance means 310a-b that have their bottom plates discharged in the first time interval, the lower the common mode voltage will be at the end of the first time interval.

The dynamic amplifier comprises replica circuitry 500 which corresponds to the amplifying circuitry (M1-M3 and the switches in the left part of figure 3a) in the dynamic amplifier. That is, the differential pair of MOS-type transistors, M1, M2, which are connected to the first and second inputs, respectively, together with a respective switch (controlled by the signal "not clk") for allowing the first and second currents to be received at the first terminals of the first and second capacitors in the first time interval have a corresponding pair of MOS-type transistors 501a-b, and switches (controlled by the signals "not clk" and "reset") for generating a current in the replica circuitry 500. The circuitry 500 preferably acts as to replicate the current I disclosed above. By replicating is meant that the total third current that is pulled from the bottom plates of the first and second capacitance means 310a-b is substantially the same as the current I flowing into the first and second capacitance means 310a-b in the first time interval. It is, however, possible to design the replica circuitry such that the third current is smaller or greater than the current I. The circuitry may be designed such that the replica current is scaled by a factor 1/K with respect to the current I as illustrated in figure 3a, where K is larger than 1. The replica current is mirrored via a current mirror formed by transistors 401 and 502 to generate the third current (discharge current) pulled from the bottom plates of the first and second capacitance means 310a-b. In case the replica current is scaled by a factor 1/K, the current mirror is preferably designed such that the mirrored current is scaled up by the same factor K.

With reference back to figures 2a-b and 3a-b, details of a method for reducing output common mode voltage of a dynamic amplifier which is adapted to amplify a signal in a first time interval under control of a clock signal will now be disclosed.

When the signal "reset" goes high and the discharge circuitry is selected by means of the signal "Ctrl[1:N], the charge transistor 402 is activated and the second terminal means (bottom plates) of the first and second capacitor means 310a-b are connected to VDD in order to pre-charge the bottom plates to VDD. At the same time the signal "reset OR clk" goes high, which turns off the grounding transistor 403.

When the signals "reset" and "not clk" goes low, the transistor M1 and the switches connected in series with the transistors M2 and M3 are activated, wherein the first capacitor means 310a, which is connected to the first output of the amplifier, is provided with a first charging (integrating) current at the first terminal means (top plates) in response to receiving an input signal at the first input 390a of the dynamic amplifier. Simultaneously, the second capacitor means 310b, which is connected to the second output of the amplifier is charged by providing a second current to the first terminal means of the second capacitor means 310b in the first time interval in response to receiving an input signal at the second input 390b of the dynamic amplifier.

While the signal "reset OR clk" is high, the signals "reset" and "not clk" goes low, which enables the discharging circuitry via discharge transistor 401 to continuously lowering the voltage potential at the bottom plates of the first and second capacitor means 310a-b, respectively. By use of the signal "Ctrl[1:N]" it is possible to control how many of the capacitors [1:N] in the first and second capacitor means 310a-b that are to be used for lowering the common mode output voltage to a desired final value.

After the first time interval (Tint) the signal "not clk" goes high and the signal "reset OR clk" goes low, which turns off the discharge transistor 401 and turns on the grounding transistor 403. The method thereafter repeats and a new cycle according to the above begins.

The present invention has been described as implemented by means of MOS-type transistors of N-type and P-type arranged in a specific way as shown in the figures. It is appreciated that the P-type transistors may be substituted by N-type and vice versa, which will not alter the working principle of the present invention but only the polarity of the voltages and currents in the circuit. That is, the present invention may be described as a dynamic amplifier for amplifying a signal in a first time interval under control of a clock signal, where the dynamic amplifier comprises: a first input and a second input; first capacitor means comprising first and second terminal means, said first capacitor means connected to a first output of said dynamic amplifier for delivering a first current at its first terminal means in the first time interval in response to receiving a signal at the first input of the dynamic amplifier; second capacitor means comprising first and second terminal means, said second capacitor means connected to a second output of said dynamic amplifier for delivering a second current at its first terminal means in said first time interval in response to receiving a signal at the second input of the dynamic amplifier; and charging circuitry connected to the second terminal means of the first and second capacitor means and adapted to continuously raise a voltage potential at the second terminal means of the first and second capacitor means in said first time interval.

The invention has mainly been described above with reference to a few embodiments. However, as is readily appreciated by a person skilled in the art, other embodiments than the ones disclosed above are equally possible within the scope of the invention, as defined by the appended patent claims.

**Claims**

1.  A dynamic amplifier for amplifying a signal in a first time interval under control of a clock signal, said dynamic amplifier comprising:

    a first input and a second input;
    first capacitor means comprising first and second terminal means, said first capacitor means connected to a first output of said dynamic amplifier for receiving a first current at its first terminal means in the first time interval in response to receiving a signal at the first input of the dynamic amplifier;
    second capacitor means comprising first and second terminal means, said second capacitor means connected to a second output of said dynamic amplifier for receiving a second current at its first terminal means in said first time interval in response to receiving a signal at the second input of the dynamic amplifier; and
    discharging circuitry connected to the second terminal means of the first and second capacitor means and adapted to continuously lower a voltage potential at the second terminal means of the first and second capacitor means in said first time interval.

2.  The dynamic amplifier according to claim 1, comprising charging circuitry connected to the second terminals of the first and second capacitor means and adapted to raise the voltage potential at the second terminals of the first and second capacitor means in a second time interval preceding the first time interval.

3.  The dynamic amplifier according to claim 2, wherein the charging circuitry comprises at least one switch connected between positive rail and the second terminals of the first and second capacitor means and adapted to connect the second terminals of the first and second capacitor means to positive rail in the second time interval.

4.  The dynamic amplifier according to any of the preceding claims, wherein the discharging circuitry comprises at least one current or voltage regulator connected to the second terminals of the first and second capacitor means, said current or voltage regulator adapted to pull a third current from the second terminals of the first and second capacitor means in the first time interval.

5.  The dynamic amplifier according to claim 4, comprising a differential pair of MOS-type transistors connected to the first and second inputs, respectively, each MOS-type transistor in series connection with a respective switch for allowing the first and second currents to be received at the first terminals of the first and second capacitors in the first time interval under control of the clock signal, wherein the current regulator comprises a corresponding pair of MOS-type transistors and switches for generating a current that is mirrored to the second terminals of the first and second capacitor via a current mirror to generate the third current.

6.  The dynamic amplifier according to any of the preceding claims, comprising:

    third capacitor means comprising a first and a second terminal, said third capacitor means connected to the first output of said dynamic amplifier for receiving a fourth current at its first terminal in the first time interval in response to receiving the signal at the first input of the dynamic amplifier, and
    fourth capacitor means comprising a first and a second terminal, said fourth capacitor means connected to the second output of said dynamic amplifier for receiving a fifth current at its first terminal in said first time interval in response to receiving the signal at the second input of the dynamic amplifier,
    wherein the second terminals of the third and fourth capacitor means are connected to signal ground.

7.  The dynamic amplifier according to any of claims 4-6, wherein said third current has a magnitude that is substantially the same as the sum of the first and second currents.

8. The dynamic amplifier according to any of claims 4-6, wherein said third current has a magnitude that is smaller than the sum of the first and second currents.

9. The dynamic amplifier according to any of the preceding claims, wherein the discharge circuitry comprises switching means adapted to connect the second terminals of the first and second capacitor means to signal ground in a third time interval subsequent to the first time interval.

10. The dynamic amplifier according to any one of the preceding claims, wherein said first and second capacitor means each comprises a plurality of capacitors, $C_{1,n}$, $C_{2,n}$, $n \in [1: N]$, N being an integer larger than one, each of said plurality of capacitors comprising a first and a second terminal.

11. The dynamic amplifier according to claim 10, comprising a plurality of discharging circuits, wherein
   the first terminal of each capacitor $C_{1,n}$ is connected to the first output of the dynamic amplifier, and the first terminal of each capacitor $C_{2,n}$ is connected to the second output of the dynamic amplifier, and
   the capacitors of said first and second capacitor means form pairs for each value of n and wherein the second terminals of at least a portion of said capacitor pairs are each connected to one of the plurality of said discharging circuits.

12. A method for reducing output common mode voltage of a dynamic amplifier adapted to amplify a signal in a first time interval under control of a clock signal, said method comprising:

   charging first capacitor means connected to a first output of the amplifier by providing a first current to first terminal means of the first capacitor means in a first time interval in response to receiving a signal at a first input of the dynamic amplifier;
   charging a second capacitor means connected to a second output of the amplifier by providing a second current to first terminal means of the second capacitor means in a first time interval in response to receiving a signal at a second input of the dynamic amplifier; and
   continuously lowering a voltage potential at second terminal means of the first and second capacitor means, respectively, in said first time interval.

13. The method of claim 12, comprising:
   raising the voltage potential at the second terminal means of the first and second capacitor means, respectively, in a second time interval preceding the first time interval.

14. The method according to any of claims 12 or 13, comprising:
   pulling a third current from the second terminal means of the first and second capacitor means in the first time interval.

15. The method according to any of claims 12-14, comprising:
   connecting the second terminal means of the first and second capacitor means to signal ground in a third time interval subsequent to the first time interval.

$\underline{100}$

Fig. 1a

Fig. 1b

Fig. 2a

Fig. 2b

EP 3 588 775 A1

Fig. 3a

$T_{int}$

reset

$\overline{clk}$

reset OR clk

Second
time
interval

First
time
interval

Third
time
interval

*Fig. 3b*

Europäisches
Patentamt

European
Patent Office

Office européen
des brevets

## EUROPEAN SEARCH REPORT

**Application Number**

EP 18 18 0728

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/313703 A1 (AGRAWAL ANKUR [US] ET AL) 13 December 2012 (2012-12-13) * paragraph [0034] - paragraph [0050]; figures 2a-8 * | 1-15 | INV. H03F3/45 H03F3/72 H03F3/187 |
| X | US 2018/183394 A1 (LIU CHUN-CHENG [TW]) 28 June 2018 (2018-06-28) * paragraph [0023] - paragraph [0027]; figures 1,2 * * paragraph [0029] - paragraph [0034]; figures 5,6 * | 1-15 | |

**TECHNICAL FIELDS SEARCHED (IPC)**

H03F
G11C
H03M
H03G

The present search report has been drawn up for all claims

| Place of search | Date of completion of the search | Examiner |
|---|---|---|
| The Hague | 8 January 2019 | Wienema, David |

EPO FORM 1503 03.82 (P04C01)

## ANNEX TO THE EUROPEAN SEARCH REPORT
## ON EUROPEAN PATENT APPLICATION NO.

EP 18 18 0728

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2019

| Patent document cited in search report | Publication date | Patent family member(s) | Publication date |
|---|---|---|---|
| US 2012313703 A1 | 13-12-2012 | NONE | |
| US 2018183394 A1 | 28-06-2018 | CN 108242918 A | 03-07-2018 |
| | | EP 3343765 A1 | 04-07-2018 |
| | | TW 201824741 A | 01-07-2018 |
| | | US 2018183394 A1 | 28-06-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **B. MALKI ; B. VERBRUGGEN ; P. WAMBACQ ; K. DEGUCHI ; M. IRIGUCHI ; J. CRANINCKX.** A complementary dynamic residue amplifier for a 67 dB SNDR 1.36 mW 170 MS/s pipelined SAR ADC. *ESSCIRC 2014 - 40th European Solid State Circuits Conference (ESSCIRC),* 2014, 215-218
- **F. VAN DER GOES et al.** A 1.5 mW 68 dB SNDR 80 Ms/s 2 x Interleaved Pipelined SAR ADC in 28 nm CMOS. *IEEE Journal of Solid-State Circuits,* December 2014, vol. 49 (12), 2835-2845
- **B. VERBRUGGEN ; M. IRIGUCHI ; J. CRANINCKX.** A 1.7 mW 11b 250 MS/s 2-Times Interleaved Fully Dynamic Pipelined SAR ADC in 40 nm Digital CMOS. *IEEE Journal of Solid-State Circuits,* December 2012, vol. 47 (12), 2880-2887
- **Y. LYU ; A. RAMKAJ ; F. TAVERNIER.** High-gain and power-efficient dynamic amplifier for pipelined SAR ADCs. *ELECTRONICS LETTERS,* 09 November 2017, vol. 53 (23), 1510-1512
- **BADR MALKI ; BOB VERBRUGGEN ; EWOUT MARTENS ; PIET WAMBACQ ; JAN CRANINCKX.** A 150 kHz-80 MHz BW Discrete-Time Analog Baseband for Software-Defined-Radio Receivers using a 5th-Order IIR LPF, Active FIR and a 10 bit 300 MS/s ADC in 28 nm CMOS. *IEEE Journal of Solid-State Circuits*